Europäisches Patentamt

European Patent Office

Office européen des brevets

(11) Publication number: **0 489 523 A1**

# EUROPEAN PATENT APPLICATION

(21) Application number: **91310818.9**

(22) Date of filing: **25.11.91**

(51) Int. Cl.5: **H01L 29/86,** H01L 29/06, H01L 39/08

(30) Priority: **04.12.90 GB 9026331**

(43) Date of publication of application:
**10.06.92 Bulletin 92/24**

(84) Designated Contracting States:
**DE FR IT NL**

(71) Applicant: **GEC-Marconi Limited
The Grove Warren Lane
Stanmore Middlesex HA7 4LY(GB)**

(72) Inventor: **Cade, Neil Alexander
36 Berry Lane
Rickmansworth, Hertfordshire WD3 4DD(GB)**
Inventor: **Johnston, Robert
10 Embleton Road
South Oxhey, Watford WD1 6PN(GB)**

(74) Representative: **George, Sidney Arthur
The General Electric Company p.l.c. GEC
Patent Department(Wembley Office) Hirst
Research Centre East Lane
Wembley Middlesex, HA9 7PP(GB)**

(54) **High-speed point contact diode.**

(57) A high-speed point contact diode is manufactured by forming a micron-sized sharp-tipped cathode (5) on a substrate (1), depositing a layer (7) of insulating material surrounding the cathode and of thickness equal to the height of the cathode, and depositing a conductive layer (13) over the insulating layer and in contact with the tip of the cathode. The cathode and the conductive layer may be formed of superconductive or refractory transition material, such as niobium.

Fig.1(g)

This invention relates to the manufacture of electronic devices, particularly point contact diodes for operation at high speeds.

High speed devices necessarily require small lateral dimensions in order to minimise the electrode capacitance and hence to minimise the charging time of such capacitance. In addition, for devices such as field emission and avalanching devices it is advantageous to achieve geometric definition of device structures on the nanometre scale to confine the emission or avalanching process geometrically.

The size of the geometric structure which may be produced by optical lithography is limited by the wavelength of the light used in the process. Coventional lithography is generally limited to dimensions greater than 0.3 $\mu$m, and even by using hard UV light the smallest feature dimensions which can be achieved are around 0.1 $\mu$m. Although smaller dimensions may be achieved by using electron beam lithography, this method is not practicable in the mass production of devices.

It is an object of the present invention to provide a method of manufacturing electronic devices whereby nanometre lateral dimensions can be achieved using conventional optical lithography techniques.

According to the invention there is provided a method of manufacturing an electronic device comprising the steps of forming at least one sharply tapered electrically-conductive body; forming a layer of insulating material over said tapered body or bodies and of thickness substantially equal to the height of each said body; and depositing an electrically-conductive layer over said layer of insulating material and in contact with the apex of the or each tapered body to form a respective point contact junction therebetween.

The electrically-conductive body or bodies and the electrically-conductive layer may each be formed of superconductive material. Alternatively, the or each electrically-conductive body may be formed of a semiconductor material of a first conductivity type with its apex of the opposite conductivity type, and the electrically-conductive layer may be formed of a metal.

Embodiments of the invention will now be described, by way of example, with reference to the accompanying drawings, in which

Figure 1(a) to 1(h) are schematic cross-sectional views illustrating stages in the formation of a high-speed diode by a method in accordance with the invention,

Figure 2 is a schematic cross-sectional view of a pair of diodes forming a microwave mixer, and

Figures 3 and 4 are schematic cross-sectional views of alternative forms of point contact diode manufactured by a method in accordance with the invention.

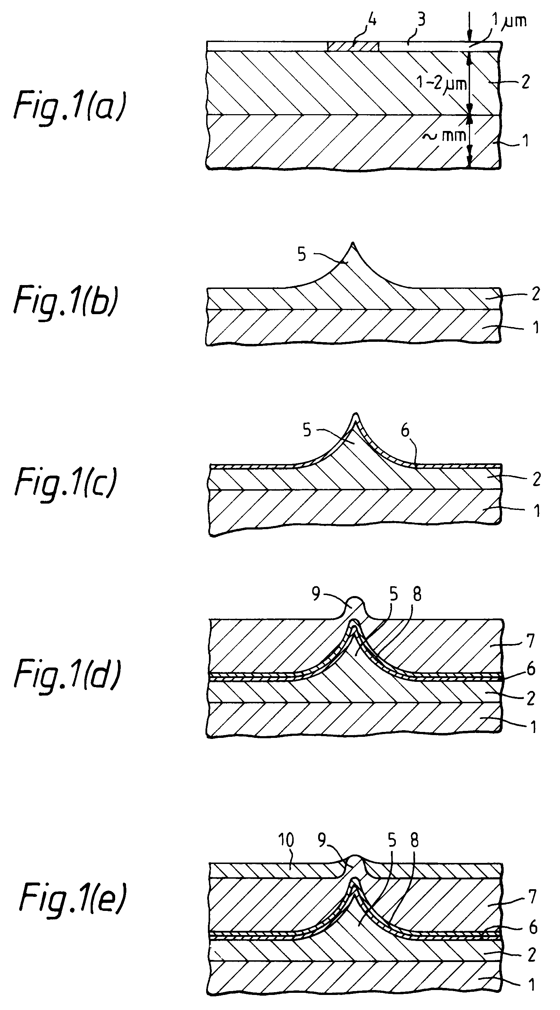

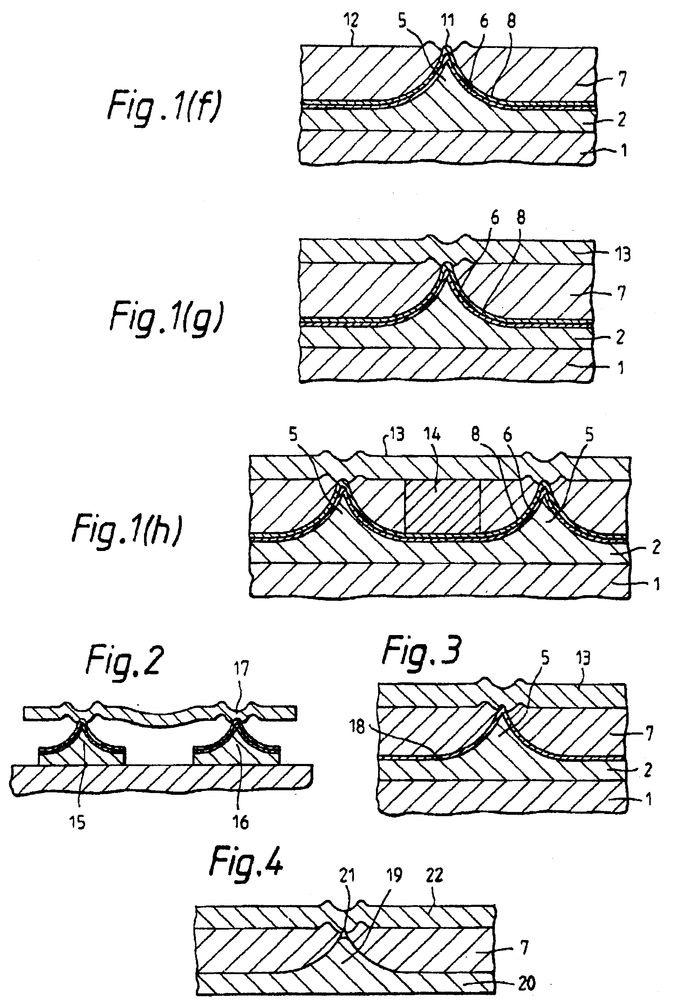

Referring to Figure 1(a) of the drawings, in a first stage in the manufacture of a high-speed point contact diode a plate substrate 1, which may be formed of, for example, silicon, sapphire, quartz or a silica glass, is prepared by depositing on a surface of the substrate a layer 2 of niobium or other suitable metal. The substrate may be a few millimetres thick and the layer 2 may be, for example, 1-2 $\mu$m thick. The layer 2 may be lithographically patterned if separate cathode tips are required.

A sharp-tipped cathode (or a plurality of such cathodes) is then produced by firstly depositing and lithographically patterning a resistant layer 3 to form a mask 4 on the layer 2. The layer 3 may be formed of, for example, a thermally-hardened photolithographic resist, a thin aluminium layer, or may comprise a thin silicon-dioxide layer, preferably formed by thermal oxidation of the surface of the silicon substrate. The mask comprises a resistant pad over each required cathode tip position. Regions of the substrate 1 and the overlying layer 2 around the pads are etched away by plasma etching, reactive ion etching, ion milling, or wet chemical etching, or any suitable combination of those techniques. In order to obtain a reproducible tip shape, and therefore a reproducible electrode capacitance, the mask 4 may be removed after a predetermined initial etching process and the etching then continued, to produce a quasistatic tip shape. This final etching may be effected by oxidation and removal of the oxide using hydrogen fluoride, particularly in the case of a silicon tip, or by, for example, reactive ion etching or ion milling. A resulting cathode tip 5 is illustrated in Figure 1(b).

The tip 5 is then surface coated (Figure 1(c)) with a layer 6 (of, say, 500Å thickness) of aluminium. The layer might alternatively be formed of any other suitable metal. A layer 7 (Figure 1(d)) of organic or inorganic electrically insulating material to a depth substantially equal to the combined height of the tip 5 and the layer 6. The layer 7 is preferably formed of $SiO_2/4\%P$ and is preferably deposited by a chemical vapour deposition technique using oxygen and silane. The presence of the oxygen during the deposition process will initially cause surface oxidation of the layer 6, so that a uniform thin film 8 of aluminium oxide is formed over the layer 6 before the layer 7 is deposited.

An upward bulge 9 the layer 7 will be produced over the tip 5. In order to remove this bulge, a layer 10 (Figure 1(e)) of a resist or of a silicon dioxide/glass slurry is spun over the layer 7 and is then heated to cause it to flow. This results in thinning of the layer 10 at the bulge 9. The bulge is then removed by, for example, plasma etching through any remaining portion of the resist layer 10 covering the bulge and then etching away the exposed bulging part of the insulating layer 7 using a selective etching process which will not substantially attack the more resistant layer 10. If the layer 7 is formed of silicon dioxide, and the layer 10 is a photoresist, this etching may be effected by use of a buffered hydrogen fluoride solution. The etching process is arrested as soon as the tip 11 (Figure 1-(f)) of the layer 8 is exposed. As a result of the etching, the surface 12 of the insulating layer 7 becomes substantially planarised.

In order to form the point contact junction, a layer 13 of niobium or other suitable metal is deposited over the layer 7. The layer 13 may be lithographically patterned, if required, to provide diode interconnections or external wiring connections.

The layer 7 may then be etched away from around the tip or tips 5 (Figure 1(h)) to reduce the capacitance still further. This may be effected by providing holes through the layer 13 at suitable positions and/or by directing etchant horizontally at the edges of the layer 7. The layer 13 then remains supported entirely by the apexes of the tips 5. On the other hand, regions 14 of the layer 7 may, if required, be retained to provide additional support for the layer 13.

The process described above therefore enables superconducting niobium tips 5 to be produced on the silicon or quartz substrate 1. If these tips are coated with layers 6 of 500Å thickness of aluminium oxidised to a depth of 30Å then the top layer 13 of niobium will produce an almost symmetrical SIS junction diode, as a result of the proximity effect in the aluminium.

In practice, a double junction mixer diode (Figure 2) would be fabricated, with two electrically-isolated tips 15,16 or two isolated patches of interconnected tips on the substrate 1, with a single niobium surface layer 17 interconnecting the two tips or patches of tips. The pair of diodes thus formed could therefore be simultaneously DC-biased to the most nonlinear gap excitation region of both diodes. This would allow microwave radiation and a local oscillator signal incident on the contact layer 17 to be combined, leading to a lower frequency difference signal at both substrate diode contacts 15, 16.

Figure 3 illustrates, schematically, an alternative form of diode formed by substantially the same processes as the device of Figure 1. In this case the aluminium layer 6 is omitted, and an insulating layer 18 of $Nb_2O_5$ is formed on the surface of the tip 5 during the deposition of the silicon dioxide layer 7. This process therefore produces a metal-insulator-metal diode particularly suitable for use as a protection device. It will be apparent that other refractory transition metals might be used in place of niobium.

The device operates by virtue of an avalanche process. Such avalanche processes are ideal for protection applications in that they result in negative differential resistance in the device and exhibit a low impedance state at high voltages. The basic mechanism of their operation is the impact ionisation multiplication of electrons in tunnelling across a thin insulator region. The low capacitance of the present structure allows improved device speed, while the reduced cathode tip area will not seriously reduce the overall current-carrying capacity of the device. This is because the multiplication process naturally results in spatially localised emission, since the whole avalanche is stimulated by one initial tunnelling electron.

Indeed, the current-carrying capacity of such a diode may be improved over a corresponding planar diode. If a number of separate tips are used in the diode, they will individually cause spatially-separated current avalanches and provide a more uniform average current distribution across the diode. In addition, the field enhancement provided by the sharp tip structure will allow operation of the device at lower voltage.

A semiconductor diode may also be manufactured by a process according to the invention. Referring to Figure 4, one or more tips 19 are formed, by the above-described process, on an n-type silicon substrate 20. After deposition of the silicon dioxide layer 7, that layer is planarised as described above, exposing the apex 21 of the tip 19. The apex is then ion implanted or diffusion doped to provide a p-type portion. An aluminium layer 22 is then deposited in contact with the apex 21 and annealed to provide an ohmic contact to the pn junction.

Alternatively, a layer (not shown) of undoped silicon could be epitaxially grown on the substrate 20 before formation of the tip(s) 19, so that when the apex is doped, the tip 5, the remainder of the undoped silicon layer and the p-type apex 21 together form a pin junction. Clearly, the conductivity types of the substrate 20 and the apex 21 may be reversed, and other suitable semiconductor materials and metals may alternatively be used.

It has recently been shown that if the capacitance of a diode can be reduced to a sufficiently small value, the change in energy of the diode, when a single electron tunnels across the diode gap, can be sufficient to impede the tunnelling of further electrons. At present this effect has been observed only at very low temperatures but with the small capacitance values exhibited by the present device geometry, operation at higher and more practicable temperature may be possible.

For this Coulomb blockade diode substantially the same geometry as that of the mixer diode might be used, but without limitation to superconducting materials. Due to the critical nature of the capacitance in this case, the capacitance could preferably be further reduced by etching away all of the insulating support layer 7, leaving the planar metal layer supported only by the tip apexes.

Applications of such a structure would include microwave sources and storage devices. More complex multi-junction structures might also allow more complex device operation.

In a further development of the Figure 1 structure the process for etching away the layer 7 might be continued until the portion of the insulating layer 8 at the apex 11 is removed, thereby leaving a gap between the tip 5 and the layer 13. This gap could be evacuated or remain air filled to form the insulator of an M-I-M diode. It would then clearly be necessary to leave regions 14(Figure 1(h)) supporting the layer 13.

The process of the present invention can therefore be used to provide a number of different point contact diode structures, each exhibiting very low capacitance. A single tip may be formed, or an array of separate or interconnected tips may be produced by suitable masking and etching. The tips of such an array may be connected in series or in parallel by standard lithographic patterning of the cathode layer, or the substrate, as the case may be. The spacings between the individual diodes would then be those obtainable by use of the lithographic process. Other devices may also be provided on the same substrate and interconnected with the diode(s).

Two parallel rows of tips might be formed, interconnected at their apexes by a layer as described above, the width of the layer being comparable to the wavelength of a microwave signal in the diodes, whereby the rows of tips terminate transmission lines of, say, 50 ohms impedance formed between the residual conductive material 2 and a "ground plane" metallic layer 22 deposited on the other side of the substrate 1.

## Claims

1. A method of manufacturing an electronic device, characterised by the steps of forming at least one sharply tapered electrically-conductive body (5); forming a layer (7) of insulating material over said tapered body or bodies and of thickness substantially equal to the height of each said body; and depositing an electrically-conductive layer (13) over said layer of insulating material and in contact with the apex of the or each tapered body to form a respective point contact junction therebetween.

2. A method as claimed in Claim 1, characterised in that the or each tapered body (5) and the conductive layer (13) are formed of superconductive material.

3. A method as claimed in Claim 2, characterised in that a layer (6) of metal is deposited on the or each tapered body (5) before formation of the layer (7) of insulating material.

4. A method as claimed in Claim 3, characterised in that the layer (6) of metal is at least partially oxidised before and/or during deposition of the layer (7) of insulating material.

5. A method as claimed in Claim 4, characterised in that the superconductive material is niobium.

6. A method as claimed in Claim 3, Claim 4 or Claim 5, characterised in that the metal is aluminium.

7. A method as claimed in Claim 1, characterised in that the or each tapered body (5) and the conductive layer (13) are formed of refractory transition material.

8. A method as claimed in Claim 7, characterised in that the surface of the refractory transition material of the or each tapered body (5) is oxidised before and/or during deposition of the layer (7) of insulating material.

9. A method as claimed in Claim 7 or Claim 8, characterised in that the refractory transition material is niobium.

10. A method as claimed in Claim 1, characterised in that the major portion of the or each tapered body (19) is formed of semiconductor material of a first conductivity type, and the apex (21) of the or each tapered body is formed of semiconductor material of the opposite conductivity type.

11. A method as claimed in Claim 10, characterised in that the semiconductor materials comprise oppositely-doped silicon.

12. A method as claimed in Claim 11, characterised in that the conductive layer (22) is formed of aluminium.

13. A method as claimed in any one of Claims 2-6, characterised in that two of said tapered bodies (15,16)or two groups of said tapered bodies are formed, said two bodies or said two groups of bodies being electrically isolated from each; and wherein said layer (17) of conductive material is dimensioned in relation to the wavelength of a microwave signal to be handled by the device.

14. A method as claimed in any one of Claims 2-6, characterised in that two of said tapered bodies (15,16) or two groups of said tapered bodies are formed with minimum spacing therebetween, said two bodies or said two groups of bodies being electrically isolated from each other; and wherein said layer (17)of conductive material has dimensions substantially no greater than required to span the apexes of the bodies.

15. A method as claimed in any preceding claim, characterised in that after deposition of the conductive layer (13) at least part of the layer (7) of insulating material is removed by etching.

Fig.1(a)

Fig.1(b)

Fig.1(c)

Fig.1(d)

Fig.1(e)

EP 0 489 523 A1

Fig.1(f)

Fig.1(g)

Fig.1(h)

Fig.2

Fig.3

Fig.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 5) |
|---|---|---|---|
| A | APPLIED PHYSICS A. SOLIDS AND SURFACES. vol. A35, no. 2, October 1984, HEIDELBERG DE pages 67 - 74; H.D.RICCIUS ET AL.: 'Point-contact diodes' * page 70 - page 73; figure 2 * | 1-15 | H 01 L  29/86 H 01 L  29/06 H 01 L  39/08 |
| A | DD-A- 147 173  (F.DETTMANN ET AL.) * page 6 - page 7; figures 3-4 * | 1-2 | |
| A | IEEE TRANSACTIONS ON ELECTRON DEVICES. vol. ED-27, no. 10, October 1980, NEW YORK US pages 1998 - 2008; R.F.BROOM ET AL.: 'Niobium oxide-barrier tunnel junction' * figure 3 * | 2-5 | |
| A | IEEE JOURNAL OF QUANTUM ELECTRONICS. vol. QE-18, no. 3, March 1982, NEW YORK US pages 428 - 432; B.G.WHITFORD 'Experimental nonlinearity coefficients for the tungsten-nickel point-contact diode' * the whole document * | 7-9 | TECHNICAL FIELDS SEARCHED (Int. Cl.5) H 01 L |
| A | APPLIED PHYSICS LETTERS. vol. 41, no. 7, 1 October 1982, NEW YORK US pages 635 - 638; P.M.PETROFF ET AL.: 'Toward quantum well wires: Fabrication and optical properties' * the whole document * | 1,10-12 | |
| A | EP-A-0 021 026  (LICENTIA PATENT-VERWALTUNG) * claim 1; figure 6 * | 1,15 | |

The present search report has been drawn up for all claims

| Place of search | Date of completion of the search | Examiner |
|---|---|---|
| BERLIN | 09-03-1992 | MUNNIX S J G |